# EUROPÄISCHE PATENTANMELDUNG

(11) **EP 0 534 130 A1**
(43) Veröffentlichungstag der Anmeldung: **31.03.1993**
(21) Anmeldenummer: 92114162.8
(22) Anmeldetag: 19.08.1992
(51) Int. Cl.: H01L 21/82, H01L 21/90

(54) **Verfahren zur Herstellung einer selbstjustierten Kontaklochanordnung und selbstjustierte Kontaktlochanordnung**

(30) Priorität: 26.09.1991 DE 4132140
(71) Anmelder: SIEMENS AKTIENGESELLSCHAFT, D-80333 München (DE)
(72) Erfinder: Vogt, Horst-Dieter Dr. rer. nat., W-8000 München 83 (DE); Vogel, Gert, Dr. rer. nat., W-8450 Amberg (DE)

(57) **Zusammenfassung**

Zur Herstellung einer selbstjustierten Kontaktlochanordung bei Halbleiterstrukturen werden ein auf einem Halbleitersubstrat (S) isoliert aufgebrachter leitfähiger Bereich (G) mit einer äußeren Isolation (O1, O2) versehen und nachfolgend großflächig zunächst eine undotierte Oxidschicht (UDO) und darauf unmittelbar eine dotierte Oxidschicht (DO) aufgebracht. Mit Hilfe einer Fototechnik (F) werden die dotierte Oxidschicht trockenchemisch isotrop selektiv und die undotierte Oxidschicht trockenchemisch anisotrop geätzt. Eine Hilfsschicht zwischen den beiden Oxidschichten als Ätzstop ist nicht nötig. Dadurch ergibt sich eine vereinfachte Prozeßführung, und störende Einflüsse wie bei einer Hilfsschicht bei späteren Prozeßschritten entfallen. Die dotierte Oxidschicht kann hochdotiert sein, wodurch sich ein besseres Verfließergebnis in einem späteren Prozeßschritt ergibt.

## Beschreibung

Die Erfindung betrifft ein Verfahren zur Herstellung einer selbstjustierten Kontaktlochanordnung und eine selbstjustierte Kontaktlochanordnung bei Halbleiterstrukturen, bei denen ein auf einem Halbleitersubstrat isoliert aufgebrachter leitfähiger Bereich mit einer äußeren Isolation versehen wird, bei denen nachfolgend großflächig zunächst eine undotierte Oxidschicht und dann eine dotierte Oxidschicht aufgebracht sind, die mit Hilfe einer Fototechnik in Ätzschritten strukturiert werden.

Die fortschreitende Verkleinerung der Strukturen in der Mikroelektronik führt dazu, daß für Justiertoleranzen und Strukturbreitenschwankungen notwenige Mindestabstände zwischen den einzelnen Strukturen für den Flächenbedarf der integrierten Schaltungen eine immer größere Rolle spielen. Mit Hilfe selbstjustierender Techniken können Toleranzabstände reduziert werden. Beispielsweise sind selbstjustierte Source- oder Drainkontakte unproblematisch bezüglich einer eventuellen Dejustierung bei deren Herstellung.

Erstmals in der Generation der 4 Megabit-Halbleiterspeicher wurde eine selbstjustierende Technik in einer Kontaktlochebene eingeführt. Aus der Veröffentlichung W. Pribyl, J. Harter, W. Müller: A 4 Megabit Dynamic RAM in Submicron CMOS Technology with a FOBIC Trench Cell, Siemens Forschungs- und Entwicklungsberichte, Bd. 16, Nr. 6, 1987, S. 253 ff. ist ein vollständig überlappender Bitleitungskontakt bezüglich des Gates des Transistors und einer Feldisolation bekannt. Ein als Gate vorgesehener auf einem Halbleitersubstrat isoliert aufgebrachter leitfähiger Bereich wird mit einer äußeren Isolation versehen, bei der oberhalb des Gates und mit Hilfe der Spacer-Technik an den Seitenwänden ein Oxid erzeugt wird. Im Querschnitt ist dabei das Gate vollständig durch Oxid isoliert und eingekapselt. Darüber werden ganzflächig zunächst eine Oxidschicht, dann eine Nitridschicht und anschließend eine weitere Oxidschicht aufgebracht. Diese Schichtenfolge erlaubt eine Kontaktlochätzung, die nicht wesentlich das Feldoxid und die Oxidisolation des Gates angreift. Üblicherweise wird die obere Oxidschicht naßchemisch isotrop geätzt, wobei die dünne Nitridschicht als Ätzstop wirkt. Anschließend werden die dünne Nitrid- und die Oxidschicht üblicherweise trochenchemisch anisotrop geätzt. Auf das so erzeugte Kontaktloch, das bis auf die Substratoberfläche hinabreicht, werden eine Polysilizium- bzw. Polyzidschicht und darüber eine Molybdänsilizidschicht aufgebracht.

Die obere, isotrop zu ätzende Oxidschicht ist üblicherweise vergleichsweise dick, da sie für einen Verfließ-Prozeßschritt zur Planarisierung der Oberfläche vorgesehen ist. Die obere dicke Oxidschicht kann bei dem bisher angewandten Verfahren nur niedrig dotiert sein, was den Verfließprozeß erschwert. Weiterhin kann die nach der anisotropen Ätzung der Nitrid- und unteren Oxidschicht verbleibende Nitridschicht bei späteren Prozeßschritten störende Auswirkungen zeigen.

Der Erfindung liegt die Aufgabe zugrunde, ein Verfahren und eine Anordnung der obengenannten Art anzugeben, mit dem der Prozeßablauf zur Herstellung der selbstjustierten Kontaktlochanordnung vereinfacht werden und die obengenannten Nachteile verringert werden können.

Die Aufgabe wird mit den Merkmalen des Patentanspruchs 1 bzw. den Merkmalen des Patentanspruchs 4 gelöst.

Die Erfindung hat den Vorteil, daß eine Hilfsschicht aus Siliziumnitrid oder Polysilizium als Ätzstop zwischen den beiden ganzflächig aufgebrachten Oxidschichten nicht mehr erforderlich ist. Dadurch wird einerseits die Prozeßführung vereinfacht und andererseits können keine störenden Einflüsse einer derartigen Hilfsschicht bei späteren Prozeßschritten auftreten. Weiterhin kann eine hochdotierte obere Oxidschicht verwendet werden, die ein erheblich besseres Verfließergebnis ermöglicht.

Ausgestaltungen der Erfindung sind in Unteransprüchen gekennzeichnet.

Die Erfindung wird nachfolgend anhand eines in den Figuren der Zeichnung dargestelltes Ausführungsbeispiel näher erläutert.
Es zeigen:
- Figuren 1 bis 4: eine Pprinzipdarstellung eines bekannten Verfahrens zur Herstellung selbstjustierter Kontaktlöcher und
- Figuren 5 bis 9: eine Prinzipdarstellung für die Herstellung einer erfindungsgemäßen selbstjustierten Kontaktlochanordnung.

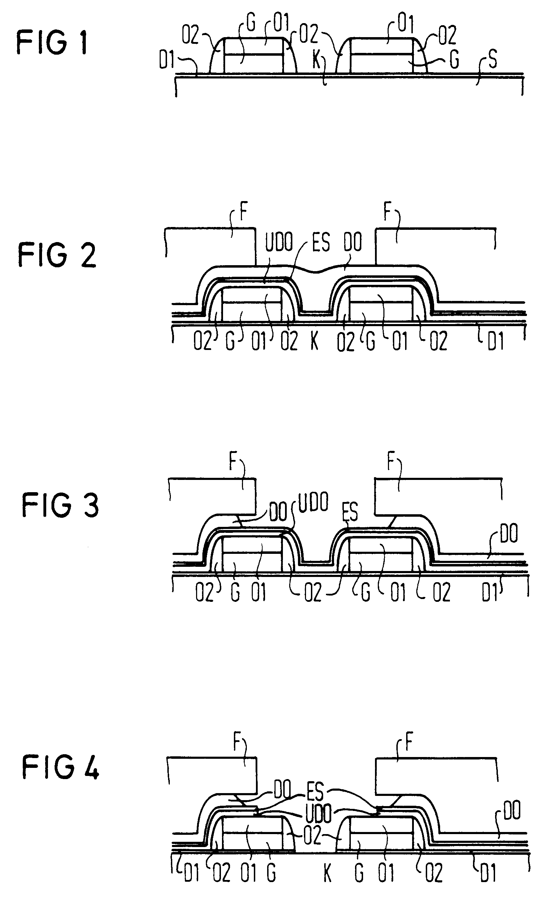

Für die Erläuterung der Erfindung wird zunächst anhand der Figuren 1 bis 4 auf ein Verfahren zur Herstellung einer selbstjustierten Kontaktlochanordnung nach dem Stand der Technik Bezug genommen. Gemäß Figur 1 werden in bestimmten Bereichen eines Substrats S, die üblicherweise durch nicht gezeichnete Feldoxide oder LOCOS-Bereiche voneinander isoliert sind, Gebiete erzeugt, die für spätere aktive Zonen mit Kontaktlöchern vorgesehen sind. Zunächst wird auf diesen Gebieten eine Dielektrikumsschicht D1 und darauf eine leitfähige Schicht aus dotiertem Polysilizium gebildet. Über der Polysiliziumschicht wird eine Oxidschicht abgeschieden, die zusammen mit der Polysiliziumschicht strukturiert wird. Auf diese Weise entstehen auf dem Substrat isoliert aufgebrachte leitfähige Bereiche G, die von Oxidzonen O1 bedeckt sind. Mit Hilfe der an sich bekannten Spacer-Technik erfolgt durch ganzflächiges Abscheiden von Siliziumoxid und anisotropes Zurückätzen, bei dem an den Seitenflanken Oxid stehenbleibt, eine Einkapselung des leitfähigen Bereichs G, so daß sich durch die Oxidzonen O1 und O2 eine äußere Isolation ergibt. Mit K ist in Figur 1 ein Bereich bezeichnet, in dem ein Kontaktloch erzeugt werden soll.

Nach der Einkapselung des leitfähigen Bereichs G wird ganzflächig eine dünne undotierte Oxidschicht UDO beispielsweise mit Hilfe des CVD-Verfahrens (Abscheidung aus der Gasphase) erzeugt. Diese dünne Oxidschicht kann beispielsweise eine Teos-Schicht (Tetraäthylorthosilikat-Schicht) sein, die ganzflächig erzeugt wird. Über dieser Schicht UDO wird eine dünne Hilfsschicht ES aufgebracht, beispielsweise aus Siliziumnitrid oder Polysilizium. Darüber wird eine vergleichsweise dicke Schicht DO dotierten Oxids, beispielsweise Phosphorsilikatglas oder Borphosphorsilikatglas aufgebracht. Die Dotierung kann beispielsweise 2,5 % Bor und 4 % Phosphor betragen. Diese dotierte Oxidschicht DO wird anschließend durch Verfließen eingeebnet. Danach wird Fotolack F aufgetragen und durch eine entsprechende Fototechnik ein Fenster erzeugt.

Gemäß Figur 3 wird nachfolgend das dotierte Oxid DO durch eine naßchemische Ätzung isotrop geätzt, wobei die Ätzung auf der dünnen Hilfsschicht, beispielsweise Nitrid, stoppt.

Gemäß Figur 4 werden danach unter Verwendung des durch die Fototechnik gebildeten Fensters die Hilfsschicht ES und die undotierte Oxidschicht UDO anisotrop trochenchemisch geätzt, wobei die Ätzung so ausgeführt wird, daß im Bereich des vorgesehenen Kontaktlochs K auch die Dielektrikumschicht D1 entfernt wird. Nach Entfernen der Fotolackschicht F kann dann beispielsweise eine Polysilizidschicht und darüber eine Molybdänsilizidschicht erzeugt werden. Aufgrund der Selbstjustiertechnik können diese Metallisierungsschichten die leitfähigen Bereiche G oberhalb der Oxidschichten O1 bzw. O2 teilweise überdecken, so daß auch bei einer Dejustierung der Maskentechnik noch eine sichere Kontaktierung des Bereichs K möglich ist.

Bei dem oben geschilderten Verfahren zur Herstellung einer selbstjustierten Kontaktlochanordnung ist die dünne Hilfsschicht ES erforderlich, da die Naßätzung der dotierten Oxidschicht DO einen Ätzstop erfordert. Die Naßätzung erlaubt andererseits wegen der Haftung des Fotolacks F nur vergleichsweise niedrige Dotierungen der dotierten Oxidschicht DO. In direkter Konsequenz ergibt sich daraus ein vergleichsweise schlechtes Verfließverhalten der dotierten Oxidschicht. Darüber hinaus macht die Hilfsschicht ES eine komplexe Prozeßführung erforderlich und wirkt bei späteren Prozeßschritten störend.

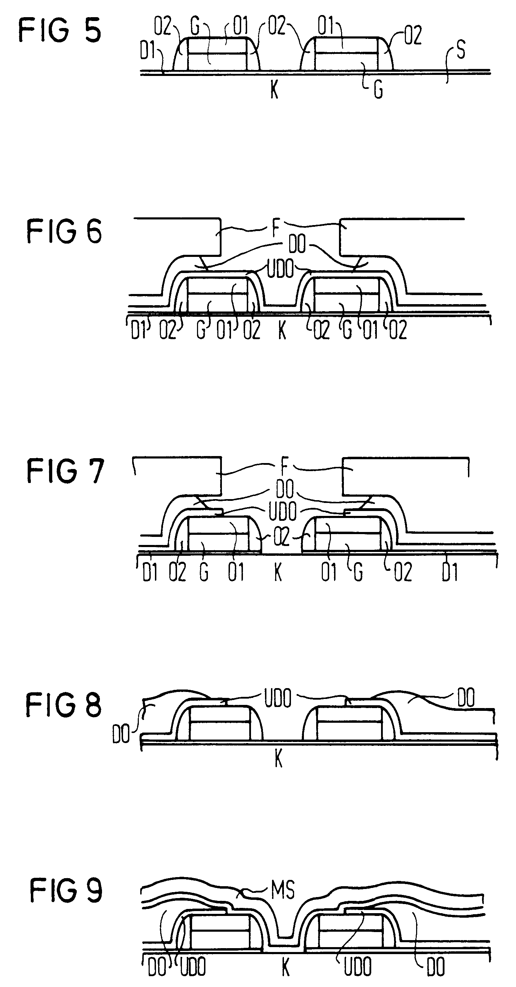

Ausgangspunkt des erfindungsgemäßen Verfahrens ist Figur 5, die identisch Figur 1 entspricht. Auf dieser Anordnung wird großflächig eine vergleichsweise dünne Schicht undotierten Oxids, beispielsweise Teos, aufgetragen. Dies kann mit Hilfe des CVD-Verfahrens erfolgen. Anschließend kann diese Schicht verdichtet werden, beispielsweise durch Tempern mit einer Temperatur von 850° bis 1000 während etwa 30 Minuten in einem Inertgas. Danach wird auf der undotierten Oxidschicht UDO eine dickere Schicht DO dotierten Oxids aufgebracht, beispielsweise Borphosphorsilikatglas. Auch die dotierte Oxidschicht DO kann beispielsweise durch Tempern verdichtet werden. Danach erfolgt das Aufbringen eines Fotolacks F und darin die Erzeugung eines Fensters, Figur 6. Die dotierte Oxidschicht DO wird anschließend durch eine trockenchemische isotrope selektive Ätzung geätzt, ohne daß das dotierte Oxid zuvor einem Verfließprozeß unterzogen wird. Da die dotierte Oxidschicht im wesentlichen überall gleich dick ist, ist es mit dem trockenchemischen isotropen Ätzschritt möglich, das dotierte Oxid DO ausreichend selektiv zum undotierten Oxid UDO zu ätzen. Gemäß Figur 7 wird danach das undotierte Oxid UDO trockenchemisch anisotrop geätzt. Durch den Ätzvorgang wird auch das Dielektrikum D1 im Bereich des Kontaktlochs K geätzt, so daß die Oberfläche des Substrats freiliegt.

Nach Entfernen der Lackschicht F erfolgt ein Verfließen der dotierten Oxidschicht DO, Figur 8. Danach kann eine Polysilizium- oder Polysilizidschicht PS und darüber eine Molybdänsilizidschicht MS aufgebracht werden, Figur 9. Damit ist der Bereich K des Substrats mit einer leitfähigen Schicht kontaktiert. Anschließend kann beispielsweise eine Siliziumoxidschicht und eine Borphosphorsilikatglasschicht aufgetragen werden, die zur Auffüllung des Kontaktbereichs und zur Planarisierung der Oberfläche dient.

Die verwendete trockenchemische isotrope Ätzung ermöglicht das selektive Ätzen der dotierten Oxidschicht zur undotierten Oxidschicht. Erfindungsgemäß ist deshalb eine Hilfsschicht zwischen den beiden Oxidschichten nicht erforderlich, wodurch die Prozeßführung einfacher wird und in späteren Prozeßschritten keine störenden Einflüsse der Hilfsschicht auftreten können. Das erfindungsgemäße Verfahren ermöglicht weiterhin die Verwendung einer hochdotierten Oxidschicht DO, beispielsweise einer Borphosphorsilikatglasschicht mit einem Anteil von 3 % Bor und 6 % Phosphor. Mit einer derartig hochdotierten Oxidschicht kann ein wesentlich besseres Verfließergebnis und damit eine ebenere Oberfläche erzielt werden. Dies wiederum hat Vorteile hinsichtlich des Aufbringens der leitfähigen Schicht für das Kontaktloch K.

## Patentansprüche

1. Verfahren zur Herstellung einer selbstjustierten Kontaktlochanordnung bei Halbleiterstrukturen, bei dem ein auf einem Halbleitersubstrat (S) isoliert aufgebrachter leitfähiger Bereich (G) mit einer äußeren Isolation (O1, O2) versehen wird, bei dem nachfolgend großflächig zunächst eine undotierte Oxidschicht (UDO) und dann eine dotierte Oxidschicht (DO) aufgebracht werden, die mit Hilfe einer Fotolackmaske (F) strukturiert werden,
**gekennzeichnet** durch folgende Schritte:
a) nach Aufbringen der undotierten Oxidschicht (UDO) wird auf dieser unmittelbar die dotierte Oxidschicht (DO) aufgebracht,
b) anschließend wird mit einer Fototechnik die Fotolackmaske erzeugt,
c) nach der Fototechnik wird die dotierte Oxidschicht (DO) trockenchemisch isotrop selektiv strukturiert,
d) danach wird die undotierte Oxidschicht (UDO) strukturiert.

2. Verfahren nach Anspruch 1,
**dadurch gekennzeichnet,**
daß nach Schritt d) die dotierte Oxidschicht (DO) verflossen wird.

3. Verfahren nach Anspruch 1 oder 2,
**dadurch gekennzeichnet,**
daß jede der beiden Oxidschichten jeweils nach ihrem Aufbringen verdichtet wird.

4. Selbstjustierte Kontaktlochanordnung bei Halbleiterstrukturen mit einem auf einem Halbleitersubstrat (S) isoliert aufgebrachten leitfähigen Bereich (G) mit einer äußeren Isolation (O1, O2) und einer großflächig aufgebrachten undotierten Oxidschicht (UDO), über der eine großflächig aufgebrachte dotierte Oxidschicht (DO) angeordnet ist, wobei die Oxidschichten zur Bildung eines Kontaktlochs (K) strukturiert sind,
**dadurch gekennzeichnet,**
daß die dotierte Oxidschicht (DO) unmittelbar auf der undotierten Oxidschicht aufgebracht und mit einer trockenchemischen isotropen selektiven Ätzung strukturiert ist.

5. Anordnung nach Anspruch 4,
**dadurch gekennzeichnet,**
daß die dotierte Oxidschicht (DO) hochdotiert ist.

6. Anordnung nach Anspruch 4 oder 5,
**dadurch gekennzeichnet,**
daß die dotierte und die undotierte Oxidschicht verdichtet sind.
